# EUROPEAN PATENT APPLICATION

(11) **EP 4 663 815 A1**
(43) Date of publication of application: **17.12.2025**
(21) Application number: 24425028.8
(22) Date of filing: 11.06.2024
(51) Int. Cl.: C25D 1/00, H01L 21/48, H01L 21/768, G01R 31/28

(54) **METHOD FOR MANUFACTURING A METAL STRUCTURE FOR AN ELECTRONIC CIRCUIT AND CORRESPONDING METAL STRUCTURE**

(71) Applicant: Microtest S.p.A., 56010 Vicopisano (PI) (IT)
(72) Inventor: AMELIO, Giuseppe, 55100 San Pietro (LU) (IT)
(74) Representative: Botti & Ferrari S.p.A.

(57) **Abstract**

Method for manufacturing a metal structure (1) designed to put a plurality of electronic devices in electric contact, comprising the steps of:
arranging a planar lower support (3);
depositing a first photoresist layer (2i) on said lower support (3);
etching said first photoresist layer (2i) so as to form at least one first through opening in said first photoresist layer (2i);
filling said at least one first through opening with a conductive material so as to form at least one first conductive segment (24₁), which mainly develops along a growth direction (X);
depositing a first metallic primary layer (32₁) on said first photoresist layer (2i);
repeating the previous steps to form other conductive segments (24ₙ) in line with the first one to define said metal structure (1);
a step of removing the photoresist layers (2ₙ) and the metallic primary layers (32ₙ₋₁) so as to release the metal structure (1).

## Description

### Field of application

The present invention relates to a method for manufacturing a metal structure provided with one or more internal electric vias.

This method allows metal structures having different sizes and configurations to be manufactured based on repeating the steps of layer overlapping.

This metal structure finds an exemplary application in a testing head designed to perform tests on electronic devices, for example integrated electronic circuits.

The metal structure allows to put at least one termination of a first device in contact with at least one termination of a second device so as to allow the connection thereof. In particular, said metal structure allows to automatically perform some desired tests on one of the two electric devices. By doing so, it is possible to identify and discard defective products.

It is also noted that the metal structure can find a useful application in any electronic equipment where a plurality of electronic terminations must be put in temporary electric contact, in particular in any testing equipment on electronic devices or components thereof.

### Prior art

In the field of the invention, it is known to use heads of contact probes of the testing head. These probes are formed by wires of special alloys which have peculiar both electrical and mechanical properties, and which form an electric contact with the contacts of the components to be tested during the measuring tests.

In the technical development, a more and more thorough miniaturisation is applied to these testing probes; moreover, often structured and complex configurations are adopted to obtain specific technological advantages such as for example the dampening of the contacts aimed at extending the service life of the device.

Obtaining these miniaturized and complex probes, as well as similar miniaturized metal structures, is particularly difficult and expensive with the current manufacturing techniques.

The technical problem underlying the present invention is thus to develop a method for manufacturing a new metal structure, in particular a new interface element, which solves, or at least mitigates, the above-lamented drawbacks, and which allows in particular an effective structural stability in the succession of the steps of the manufacturing method.

### Summary of the invention

The solution idea underlying the present invention is to develop a new method for manufacturing a guide track inside which metallic conductors performing the function of metal structures for connecting electronic components to each other, for example the probe function, are embedded, where the stability of the method and the right planarization of the various layers, as well as a better growth of the metallic conductors are preferably ensured by the use of more than one primary layer (in English: seed layer).

The above-identified technical problem is solved in particular by a method for manufacturing a metal structure designed to put a plurality of electronic devices in electric contact, comprising the steps of:
a) arranging a planar lower support;
b) depositing a first photoresist layer on said lower support;
c) etching said first photoresist layer so as to form at least one first through opening in said first photoresist layer;
d) filling said at least one first through opening with a conductive material so as to form at least one first conductive segment, which mainly develops along a growth direction;
e) depositing a first metallic primary layer on said first photoresist layer;
f) depositing a second photoresist layer on said first metallic primary layer;
g) etching said second photoresist layer and said first metallic primary layer so as to form at least one second through opening in said first photoresist layer and in said first metallic primary layer, at least partially in line with said first through opening;
h) filling said at least one second through opening (with a conductive material so as to form at least one second conductive segment;
i) repeating the steps (e, f, g, h) up to reach a desired number of conductive segments which are contiguous to each other so as to define said metal structure.
j) a step of removing the photoresist layers and the metallic primary layers so as to release the metal structure.

The so-obtained metal structure can also comprise a plurality of independent and joined conductive objects.

Moreover, an additional step of embedding the metal structure in an elastomeric matrix can be provided, so as to obtain a bearing with internal conductors defined by said metal structure.

Preferably, said lower support comprises at least one substrate and at least one metallic primary base layer above said substrate.

Still preferably, said lower support further comprises a dielectric sacrificial layer interposed between said at least one substrate and at least one metallic primary base layer.

The step of forming the through openings can be divided into two distinct sub-steps, a first step in which the photoresist is etched, a second step in which the metallic primary layer is etched.

The photoresist etching can be performed for example according to a lithographic process.

The etching of the metallic primary layer can be performed for example according to an etching technique.

Preferably, the step of filling said at least one through opening with a conductive material, repeated for each photoresist layer and/or for each metallic primary layer, is performed through galvanic growth or cathode sputtering or thermal evaporation or other deposition techniques.

Each different photoresist layer can be a positive photoresist layer or a negative photoresist layer, with a possible alternation in the same method.

One of the conductive segments can be at least partially misaligned with respect to the immediately preceding and/or immediately following conductive segment along said growth direction, so as to be able to manufacture metal structures having an articulated and complex shape.

Preferably, the method comprises a further step of removing the lower support, so as to completely release the metal structure.

Preferably, before the steps of depositing a metallic primary layer a mechanical and/or chemical planarization step is performed on the deposition surface of said metallic primary layer.

The deposition of the metallic support layer can occur through sputtering, thermal evaporation or other deposition techniques.

The metallic primary layers can be made of identical materials or different materials; the deposition techniques being used can be different from layer to layer as well.

The above-identified technical problem is also solved by a metal, that is conductive, structure, which can be used in the electronic field, designed to put at least one termination of a first device in contact with at least one termination of a second device, being manufactured by a method of the above-outlined type.

A person skilled in the art will appreciate how the above method for manufacturing a metal structure allows an advantageous manufacture of the metal structure avoiding the use of an elastomeric matrix to keep the cohesion of the segments, with subsequent process simplification and with the possibility to manufacture structures which are independent of the elastomer.

In this case, the function of preliminary support during the formation of the electric vias is performed by a plurality of photoresist layers and primary layers, alternated with each other, and which can be easily added and dissolved.

Advantageously, this method provides the possibility of alternating among the various arranged photoresist layers, negative photoresist layers and positive photoresist layers arranged in any combination.

Advantageously, one of the faces of the device, for example the lower face, can be integrally associated with an electronic substrate with which the electrical connection must be performed. This substrate can be a printed board, a wafer, or other device or device part.

In a possible embodiment of the present invention each of said conductors comprises a plurality of conductive segments oriented in a different direction and overlapped in the vertical direction.

Thanks to this expedient, it is possible for example to form a spring structure wherein the segment alternation confers elasticity to the entire conductor and, accordingly, to the interface element.

Preferably, the conductive segments are, in this case, vertical conductive segments, oriented along the vertical direction, alternated with horizontal segments, oriented along a direction which is horizontal to the faces of the metal structure.

A bending of the successive vertical segments can be thereby obtained, while keeping the substantial linearity of the entire conductor, thus forming the above-discussed spring structure.

Preferably, said horizontal segments are vertically overlapped, while said vertical segments are vertically overlapped two by two.

This conformation keeps the axial sizes of the conductors limited.

In the here-outlined spring structure, the different conductors have an identical structure with respect to each other, the vertical segments of the different conductors being parallel and equally spaced from each other, the horizontal segments of the conductors lying on a same intermediate plane of the interface element.

The features and advantages of the assembly method will be apparent from the description of an exemplary embodiment given by way of nonlimiting example with reference to the attached drawings.

### Brief description of the drawings

Figure 1 schematically shows a general photoresist layer;
Figures 2-13 schematically show the successive steps of a process for manufacturing a metal structure.

### Detailed description

With reference to the figures of the attached drawings, a metal structure designed to put at least one termination of a first device in contact with at least one termination of a second device is globally and schematically identified with 1.

It should be first pointed out that the figures are schematic views and are not drawn to scale but so as to emphasize the most important aspects and features of the present disclosure. The shapes of the elements and of the parts composing the metal structure are not to be understood in a binding sense as well.

The metal structure 1 is illustrated in the figures in an embodiment configuration. The relative and absolute positions and orientations of the various parts composing the structure, defined by terms like upper and lower, above and below, horizontal and vertical or other equivalent terms, are always to be construed with reference to this configuration.

As identified in the paragraph dedicated to the field of application, the metal structure 1 allows to put at least one termination of a first device in contact with at least one termination of a second device, so as to play the role of an electric connection. The metal structure 1 can act in particular as a testing head automatically performing some desired tests on the electric device to be tested allowing defective products to be discarded.

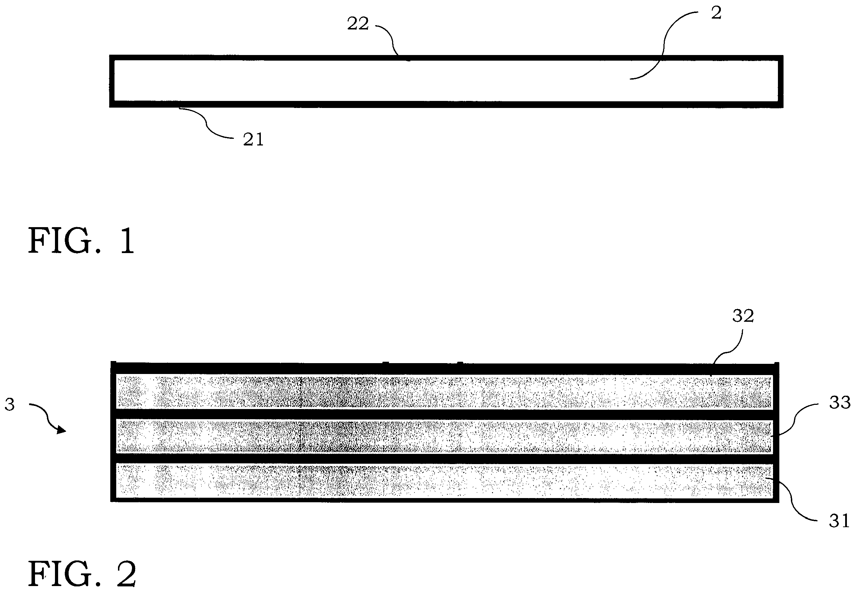

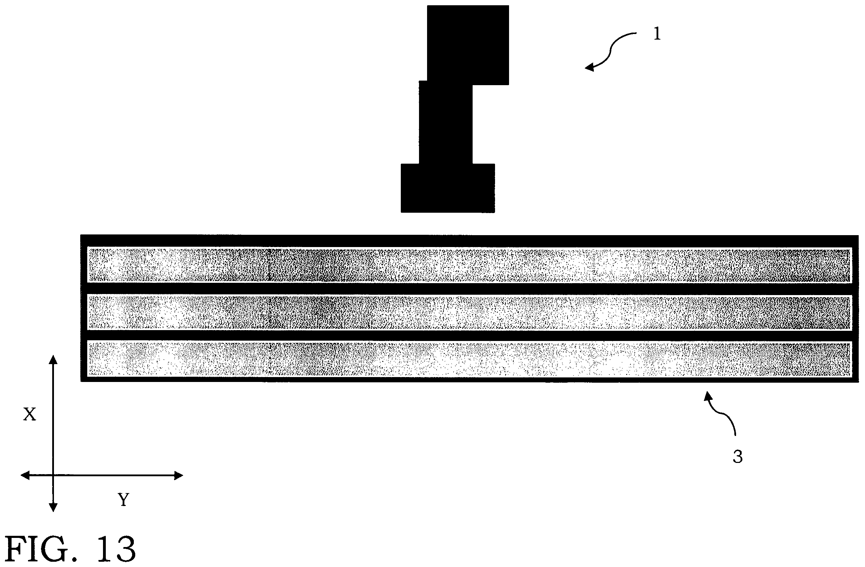

A metal structure 1, which can be individually seen in Figure 13, is obtained through a manufacturing process by successive layers, illustrated in figures 2 to 13 and described hereafter.

A general photoresist layer 2 is schematically illustrated in Figure 1. Said layer extends between a general lower face 21 and upper face 22, which are both horizontal.

In the detailed description of the process, for all that concerns the photoresist layers 2, after the number indicating the element subscripts from 1 to n will be associated, so as to allow in an easier manner a placement of the layer which is referred to, thus allowing a clearer explanation of the method. As mentioned, the subscripts will range from 1 to n, where the subscript 1 will be associated with the first photoresist layer while n will be associated with the last photoresist layer.

In a first method step a lower support 3, which can be seen in Figure 2, is arranged. Preferably, said lower support 3 comprises at least one substrate 31.

Said lower support 3 can further comprise a metallic primary base layer 32 and/or a sacrificial layer 33.

Afterwards, in a second method step, a first photoresist layer 2₁ is deposited on said lower support 3. The first layer extends between a lower face 21₁ and an upper face 22₁, which are both horizontal and arranged parallel to a horizontal direction Y.

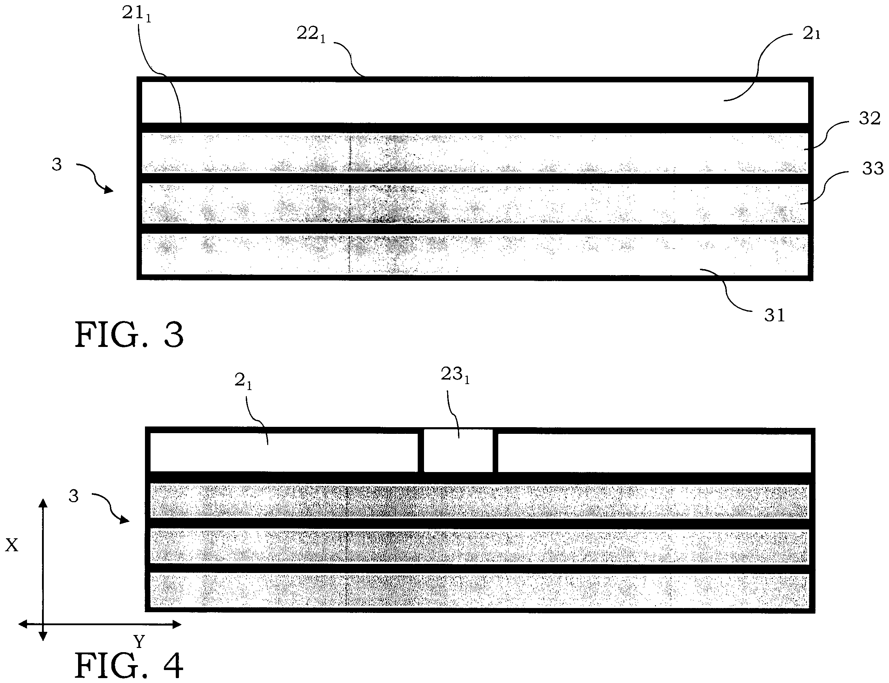

In this regard, the configuration comprising a single photoresist layer 2₁ and the layers belonging to the lower support 3 is shown in Figure 3. It should be clarified how the placement order of the layers in the lower support 3 illustrated is to be understood in a demonstrative and nonlimiting manner.

In a third method step, illustrated in Figure 4, the first photoresist layer 2₁ is etched so as to form a first through opening 23₁. It should be specified that the number of through openings 23₁ represented in Figure 4 is simply illustrative and it has not to be understood in a limited manner.

The etching of the photoresist layer 2₁ can occur, in a known manner per se, by using a lithographic process.

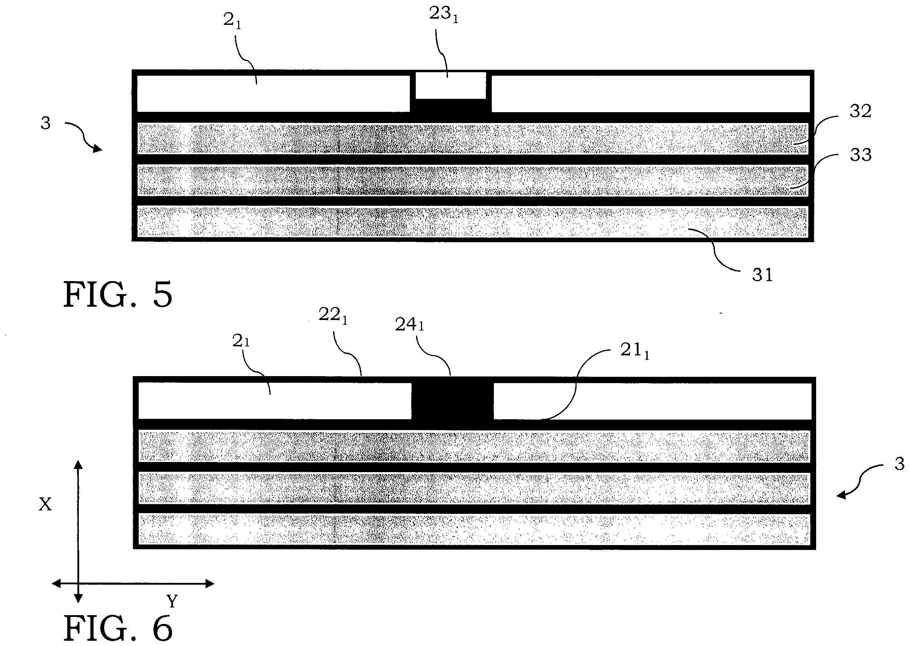

The above first through opening 23₁, obtained in said photoresist 2₁, connect the upper face 22₁ to the lower face 21₁ and in a fourth method step, shown in Figure 5, said first through opening 23₁ is gradually filled with a conductive metal up to reach a configuration, shown in Figure 6, in which the filling of said first through opening 23₁ results in the formation of a first conductive segment 24₁, which connects the lower face 21₁ to the upper face 22₁ of said photoresist layer 2₁.

Moreover, all the conductive segments 24 obtained in the general photoresist layer 2 take the thickness, in a growth direction X, which is orthogonal to the horizontal direction Y, of the photoresist layer 2 on which they are obtained and they can have a different length, in said horizonal direction Y, the one with respect to the other.

The above filling with a conductive metal can be performed through galvanic growth or cathode sputtering or thermal evaporation or other deposition techniques.

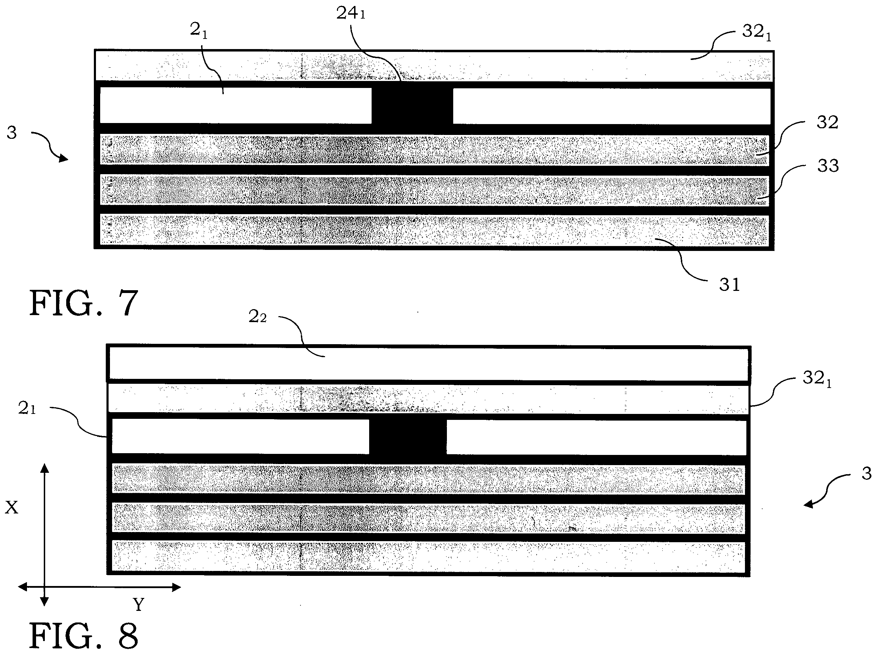

In a fifth method step, a first metallic primary layer 32₁ is deposited above a first photoresist layer 2₁, as shown in Figure 7.

Similarly to what is specified for the photoresist layers 2 also for all that concerns the metallic primary layers 32, after the number indicating the element subscripts from 1 to n will be associated, so as to allow in an easier manner a placement of the layer which is referred to, thus allowing a cleared explanation of the method.

In a following step, illustrated in Figure 8, a further photoresist layer 2₂ is deposited above said first metallic primary layer 32₁.

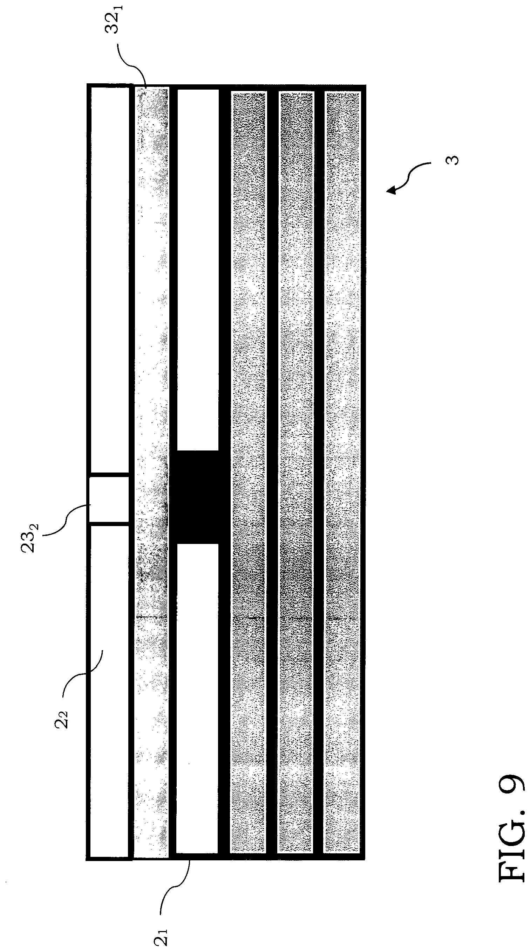

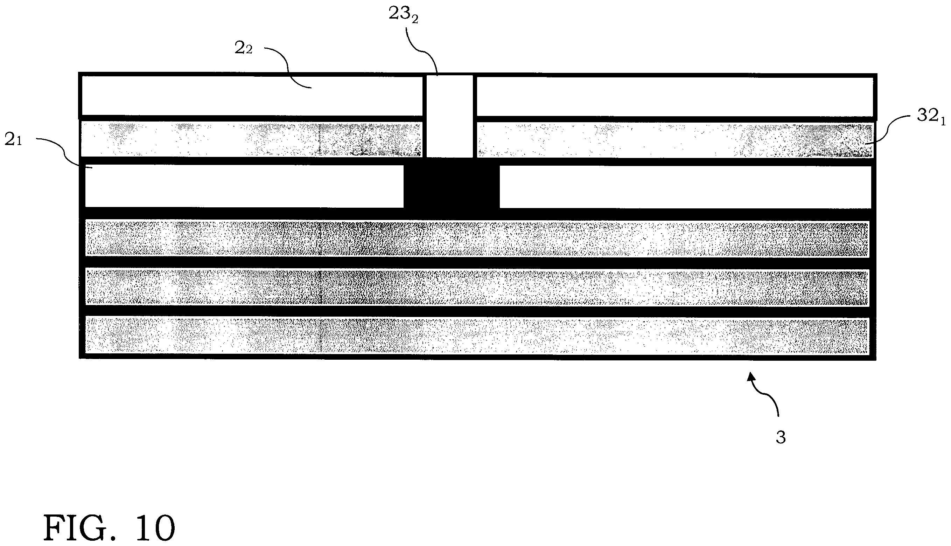

A following method step is illustrated in Figures 9 and 10, in which at first said photoresist layer 2₂ and then said first metallic primary layer 32₁ are etched, so as to form a second through opening 23₂, where said second through opening 23₂ obtained in the successive photoresist layer 2₂ and in the first metallic primary layer 32₁ is in line with said first through opening 23₁ of the previous photoresist layer 2₁.

The etching to obtain the through openings 23ₙ can occur through a lithographic process.

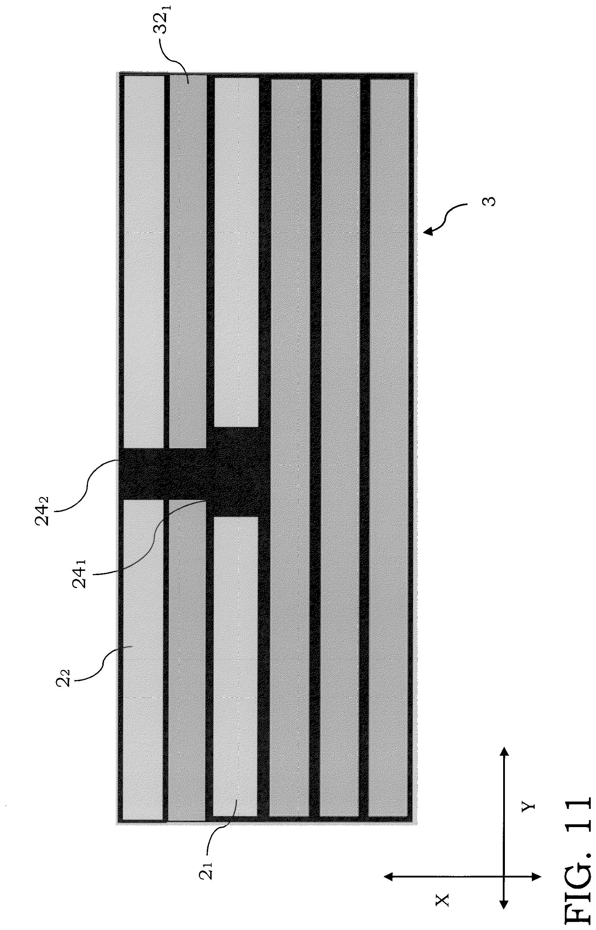

As for the previous layer, and as it can be clearly seen in Figure 11, said second through opening 23₂ obtained in said successive photoresist layer 2₂ and in said first metallic primary layer 32₁ can be filled with a conductive material so as to form a second conductive segment 24₂.

Once the second conductive segment 24₂ is formed, the process described for the first metallic primary layer 32₁ and for the successive photoresist layer 2₂ is cyclically repeated up to reach the desired conductive segments 24ₙ. The thickness of the successively deposited photoresist layers 2ₙ and metallic primary layers 32ₙ can vary, depending on the design requirements and on the desired metal structure 1, so as to obtain conductive segments 24 which are more or less extended along the growth direction X.

Specifically, it is possible to repeat in a cyclic sequence and in the described order the method steps comprising depositing the metallic primary layer 32, depositing the photoresist layer 2, etching the photoresist layer 2 and the metallic primary layer 32 so as to obtain at least one through opening 23, and filling said at least one through opening 23 so as to obtain the formation of a conductive segment 24.

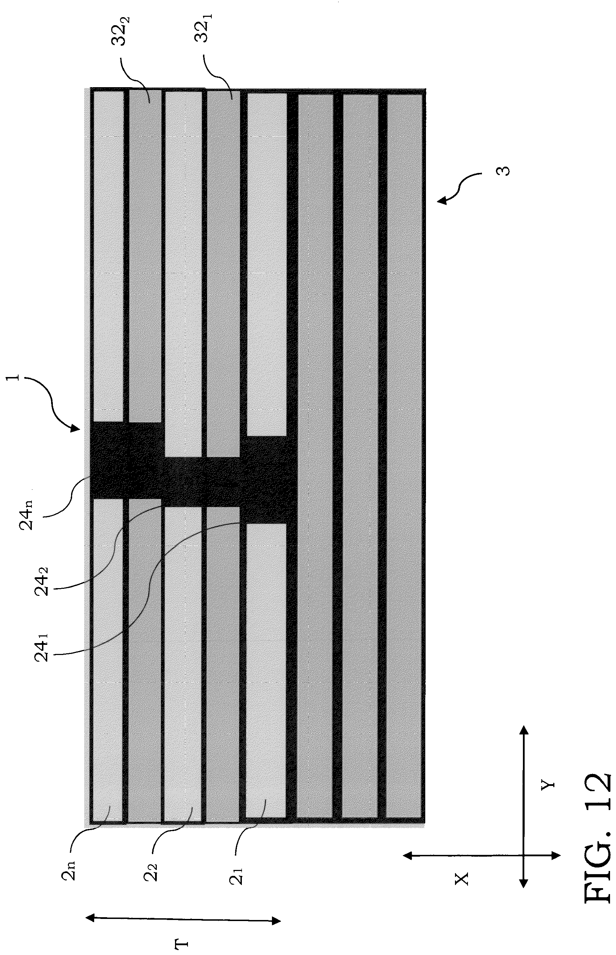

The different conductive segments 24 can be aligned with the previous and/or the next ones or misaligned. An example of metal structure can be seen in Figure 12.

In the case of misaligned conductive segments 24 an intermediate step can be performed through the known lift-off additive technique.

The cyclic repetition of these steps leads to the manufacture of a multilayer block 4 composed of metallic primary layers 32 and photoresist layers 2.

The multilayer block 4 substantially comprises a plurality of photoresist layers 2 and metallic primary layers 32, from layer 1 to layer n, wherein one or more conductive segments 24 are formed. Said plurality of photoresist layers 2 and metallic primary layers 32 are overlapped to define an overall thickness T developed along the growth direction X.

A step of mechanical and/or chemical planarization can be performed between one layer and the other one of said multilayer block 4, for example through lapping machines, or through other physical or chemical etching techniques.

In a final method step, which can be seen in Figure 13, the removal of the photoresist layers 2 and metallic primary layers 32 occurs. The photoresist 2 is chemically removed while the metallic primary layer 32 is removed through physical and/or chemical etching techniques.

If required, the removal of the lower support 3 can be performed so as to obtain said metal structure 1.

Hence, the solution of the present disclosure solves the technical problem and achieves several advantages including: a particularly reduced cost, a great structural and functional reliability and an optimum adaptability of the manufacturing process.

In understanding the scope of the present invention, the term "comprising" and derivatives thereof, as used herein, are intended as open terms which specify the presence of the specified features, elements, components, groups, integers and/or steps, but do not exclude the presence of other non-specified features, elements, components, groups, integers and/or steps. The foregoing also applies to words having similar meanings such as for example the terms "including", "having" and derivatives thereof. Moreover, the terms "cover", "face", "section" and "portion" when used in the singular form may have the double meaning of a single part or of a plurality of parts unless otherwise specified.

Although only selected embodiments were chosen to illustrate the present invention, it will be apparent to the persons skilled in the art from this disclosure that various changes and modifications can be made here without departing from the scope of the invention as defined in the attached claims.

## Claims

1. A method for manufacturing a metal structure (1) designed to put a plurality of electronic devices in electric contact, comprising the steps of:
a) arranging a planar lower support (3);
b) depositing a first photoresist layer (2₁) on said lower support (3);
c) etching said first photoresist layer (2₁) so as to form at least one first through opening (23₁) in said first photoresist layer (2₁);
d) filling said at least one first through opening (23₁) with a conductive material so as to form at least one first conductive segment (24₁), which mainly develops along a growth direction (X);
e) depositing a first metallic primary layer (32₁) on said first photoresist layer (2₁);
f) depositing a second photoresist layer (2a) on said first metallic primary layer (32₁);
g) etching said second photoresist layer (2₂) and said first metallic primary layer (32₁) so as to form at least one second through opening (23₂) in said first photoresist layer (2₁) and in said first metallic primary layer (32₁), at least partially in line with said first through opening (23₁);
h) filling said at least one second through opening (23₂) with a conductive material so as to form at least one second conductive segment (24₂);
i) repeating the steps (e, f, g, h) up to reach a desired number of conductive segments (24ₙ₋₁) which are contiguous to each other so as to define said metal structure (1).
j) a step of removing the photoresist layers (2ₙ) and the metallic primary layers (32ₙ₋₁) so as to release the metal structure (1).

2. The method for manufacturing a metal structure (1), according to one of the previous claims, wherein said lower support (3) comprises at least one substrate (31) and at least one metallic primary base layer (32) above said substrate (31).

3. The method for manufacturing a metal structure (1) according to claim 2, wherein said lower support (3) further comprises a dielectric sacrificial layer (33) interposed between said at least one substrate (31) and at least one metallic primary base layer (32).

4. The method for manufacturing a metal structure (1) according to any one of the previous claims, wherein the step of forming said at least one through opening (23), repeated for each photoresist layer (2), is performed according to a lithographic process.

5. The method for manufacturing a metal structure (1) according to any one of the previous claims, wherein the step of forming said at least one through opening (23), repeated for each metallic primary layer (32ₙ), is performed according to an etching technique.

6. The method for manufacturing a metal structure (1), according to any one of the previous claims, wherein the step of filling said at least one through opening (23n) with a conductive material, repeated for each photoresist layer (2n) and/or for each metallic primary layer (32ₙ), is performed through galvanic growth or cathode sputtering or thermal evaporation or other deposition techniques.

7. The method for manufacturing a metal structure (1), according to any one of the previous claims, wherein each different photoresist layer (2n) is a positive photoresist layer or a negative photoresist layer.

8. The method for manufacturing a metal structure (1), according to any one of the previous claims, wherein at least one of the conductive segments (24ₙ) is misaligned with respect to the immediately preceding and/or immediately following conductive segment (24) along said growth direction (X).

9. The method for manufacturing a metal structure (1), according to any one of the previous claims, comprising a further step of removing the lower support (3).

10. The method for manufacturing a metal structure (1), according to any one of the previous claims, wherein, before the steps of depositing a metallic primary layer (32ₙ), a mechanical and/or chemical planarization step is performed on the deposition surface of said metallic primary layer (32ₙ).

11. The method for manufacturing a metal structure (1), according to any one of the previous claims, wherein the deposition of the metallic support layer can occur through sputtering, thermal evaporation or other deposition techniques.

12. The method for manufacturing a metal structure (1), according to claim 11, wherein said metallic primary layers (32ₙ) are made of identical materials or different materials.

13. A metal structure (1), which can be used in the electronic field, designed to put at least one termination of a first device in contact with at least one termination of a second device, being manufactured by a method according to any one of the previous claims.
